# EUROPEAN PATENT SPECIFICATION

(11) **EP 4 636 411 B1**
(45) Date of publication and mention of the grant of the patent: **22.07.2026**
(21) Application number: 25201128.3
(22) Date of filing: 22.03.2023
(51) Int. Cl.: G01R 22/06

(54) **DETERMINING AN ELECTRIC FAULT LOCATION IN AN ELECTRICAL DISTRIBUTION NETWORK**
BESTIMMUNG EINER ELEKTRISCHEN FEHLERSTELLE IN EINEM ELEKTRISCHEN VERTEILUNGSNETZ
DÉTERMINATION D'UN EMPLACEMENT DE DÉFAUT ÉLECTRIQUE DANS UN RÉSEAU DE DISTRIBUTION ÉLECTRIQUE

(30) Priority: 31.03.2022 US 202263325977 P; 19.08.2022 US 202263399327 P
(43) Date of publication of application: 22.10.2025
(62) Divisional of application: 23717727.4
(73) Proprietor: Landis+Gyr Technology, Inc., Alpharetta, GA 30022 (US)
(72) Inventor: TOULGOAT-DUBOIS, Frederic Charles, Alpharetta, 30022 (US); STENBERG, David, Lafayette, 47904 (US); ZERPA, Carson, Vero Beach, 32963 (US)
(74) Representative: Marks & Clerk LLP

(56) References cited:
- CN-A- 108 519 503
- KR-A- 20150 075 748
- KR-A- 20200 091 977
- US-A1- 2009 265 123

## Description

### Technical Field

The present disclosure generally relates to enhanced power outage notification messaging that may be used to determine a location of a fault in an electrical distribution network.

### Background

An electrical distribution network is comprised of numerous interconnected devices over a large geographic area. The interconnected devices are generally used to monitor and distribute power to user premises, and may include power assets, such as transformers, protective devices such as switches, line sections, and meters associated with user premises. Devices such as meters and other sensors are distributed throughout the electrical distribution network to measure consumption and monitor characteristics of the electrical distribution network such as voltage, current, and power. The meters and sensors communicate characteristics of the electrical distribution network to a central system.

The central system and the meters generally communicate on a scheduled basis, or in response to when an event, such as an outage, occurs. When meters detect outage events, the meters either log the event or notify the central system by transmitting an outage notification message. Outage notification messages however lack detailed information regarding the location of a fault causing the outage. Due to the complex nature of electrical distribution networks, the first meter that detects an outage is not always the meter closest to the fault causing the outage. Prior art document US2009/265123 discloses an electricity meter that detects power outages and sends an alarm message to an external unit or server.

Thus, there is a need for improved outage notification messaging to indicate location of faults causing outages.

### Summary

The present invention provides a method of operating a meter according to claim 1, as well as a meter according to claim 9. The present disclosure includes a meter that may be connected to an electrical distribution network. The meter includes metrology for measuring waveform data associated with the electrical distribution network; communication components such as a communications module for communicating with a central system; and a processing unit for determining an outage has occurred, generating power outage notification messages, and determining a disturbance magnitude value, also referred to as a distance to fault value.

In one example, the meter determines whether an event such as a momentary outage, sustained outage, or other event has occurred, and the meter adjusts operation based on the event. For example, where the event is a momentary outage, the meter may store the disturbance magnitude value in memory and wait to transmit information about the outage and the disturbance magnitude value until the meter is queried or the meter transmits a scheduled communication.

In other examples, such as where a sustained outage has occurred, the meter may transmit an outage notification message and disturbance magnitude value to the central system without being queried by the central system. For example, the meter may include preset instructions to transmit an outage notification message and disturbance magnitude value after the meter detects voltage associated with the electrical distribution network outside of a predetermined range for a predetermined period of time.

These examples are mentioned not to limit or define the limits of the present subject matter, but to provide an example to aid understanding thereof. Illustrative examples are discussed in the Detailed Description, and further description is provided there. Advantages offered by various examples may be further understood by examining this specification and/or by practicing one or more examples of the claimed subject matter.

### Brief Description of the Figures

These and other features, aspects, and advantages of the present disclosure are better understood when the following Detailed Description is read with reference to the accompanying drawings, where:
Fig. 1 is a flowchart illustrating an exemplary method of operation of a meter transmitting an outage notification message.
Fig. 2 is a flowchart illustrating an exemplary method of operation of a meter during a momentary outage.
Fig. 3 illustrates operation of an exemplary meter during a sustained outage.
Fig. 4 illustrates operation of an exemplary meter during a momentary outage.
Fig. 5 is a flowchart illustrating an exemplary method of operation of a meter storing disturbance magnitude values in memory.
Fig. 6 is a block diagram illustrating components of an exemplary meter.
Fig. 7 is a block diagram illustrating a portion of an exemplary electrical distribution network.
Fig. 8 is a block diagram illustrating an exemplary communications network for an electrical distribution network.

### Detailed Description

Aspects of the present disclosure relate to a system for transmitting enhanced outage information. Outage notification messages indicate that an outage has occurred on an electrical distribution network and are generated at a meter when the meter detects an outage. The meter determines an outage has occurred when characteristics of the electrical distribution network measured by the meter, such as voltage or current, are outside of a predetermined range of values for a predetermined period of time.

Momentary outages and sustained outages differ from one another based on the length of time that the outage persists. The length of time that an outage persists in order for an outage to be determined by the meter to be momentary or sustained is determined by utility providers and regulatory bodies, and may be preset at the meter.

The meter's operation may vary based on whether the outage is sustained or momentary. When the meter determines that the outage is sustained, the meter may send an outage notification message including a disturbance magnitude value to the central system or other remote system. The outage notification message alerts the central system to the outage, and the disturbance magnitude value provides probabilistic information as to whether the location of the cause of the outage is closest to the meter that sent the disturbance magnitude value.

When the meter determines that an outage is momentary, the meter may store the disturbance magnitude value in memory such as a buffer, and may wait to transmit the disturbance magnitude value.

The disturbance magnitude value is determined by the meter from waveform data collected by the meter around the time of the power outage. The disturbance magnitude value indicates the meter's distance to the fault relative to other meters. For example, when a fault corresponds to a downed line, then a meter connected to the downed line may determine a disturbance magnitude value that indicates the meter is closer to the fault than a disturbance magnitude value determined by a meter connected to a different line.

A larger or more extreme disturbance in the waveform data indicates that a meter is closer to the fault than another meter with a smaller or more attenuated disturbance. A disturbance includes variations or deviations from nominal operating conditions indicating a potential fault. In one implementation, the disturbance magnitude value is represented by a value between 0 and 1, where a higher value indicates that the meter is closer to the fault than a lower value. An exemplary disturbance magnitude value may be based on voltage characteristics, such as a voltage exceeding a voltage threshold, as well as changes in voltage over time including how quickly the voltage decays, spikes in voltage, or other changes in voltage. For example, unplanned outages may involve irregular patterns of voltage decay and restoration as faults caused by tree branches, animals, or other factors may be intermittent and may occur before a stable fault current triggers opening a grid switch. In one example, the disturbance magnitude value may be calculated using an RMS average of each line cycle at half cycle increments. When this value goes below a threshold triggering calculation of the disturbance magnitude value, subsequent values after the initial voltage decay may be evaluated. RMS values above a second threshold may be summed together for up to a fixed number of half cycle periods to determine the disturbance magnitude value for a meter. If a sustained outage then occurs, the disturbance magnitude values for additional meters may be determined to estimate the meter likely closest to the fault. In other examples, a transient calculation may be used evaluating each sample in the waveform for its absolute value against a threshold.

The central system may receive multiple outage notification messages and disturbance magnitude values, as outages tend to affect multiple devices and locations. When the central system receives the disturbance magnitude values, the central system determines an area where the outage is located. The central system uses the disturbance magnitude values and maintains topological and geographic information of the electrical distribution network to determine probable locations of faults.

### Exemplary Methods of Operation

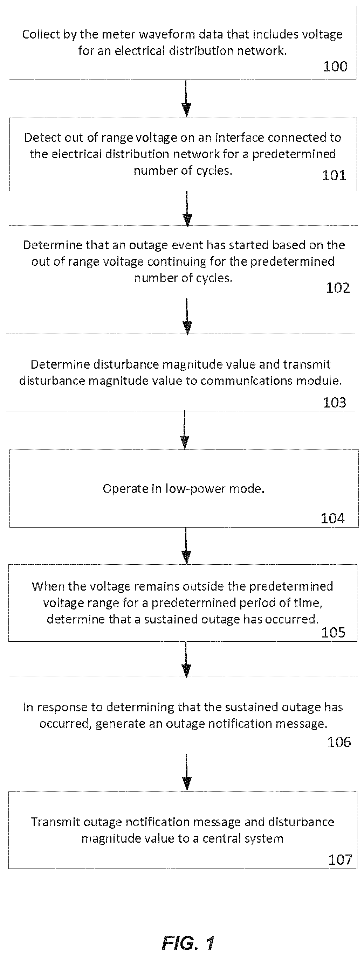

Fig. 1, Fig. 2, and Fig. 5 are flowcharts showing illustrative methods for operation of the meter. In some examples, some of the steps in flow charts of Figs. 1, 2, and 5 are implemented in program code executed by a processor of the meter. In some examples the steps shown in Figs. 1, 2, and 5 are performed in a different order or one or more steps may be skipped. Alternatively, in some examples, additional steps not shown in Figs. 1, 2, and 5 may be performed.

Figs. 1, 2, and 5 each illustrate that the meter collects waveform data from the electrical distribution network. The waveform data may include voltage waveform data, current waveform data, or other types or combinations of waveform data. The waveform data may be for a single phase or multiple phases of the electrical distribution network. The meter may buffer the waveform data so that the waveform data is available for analysis, including the calculation of a disturbance magnitude value. In one example, the meter buffers approximately 30 cycles of waveform data. For simplicity, voltage waveform data and voltages are used in the examples herein.

### Exemplary Method of Operation of a Meter During a Sustained Outage

Fig. 1 is a flow chart illustrating an exemplary method of operation of a meter transmitting an outage notification message. The method starts at Step 100, where the meter collects waveform data that includes voltage associated with an electrical distribution network.

The meter detects an out of range voltage on an interface connected to the electrical distribution network for a predetermined number of cycles (Step 101), and the meter determines that an outage event has started based on the out of range voltage (Step 102). In other examples, the meter may determine that an outage event has occurred based on out of range voltage for a predetermined period of time.

When the meter determines that an outage event has started, the meter determines a disturbance magnitude value based on waveform data collected by the meter and transmits the disturbance magnitude value to a communications module of the meter (Step 103).

The meter may continue to operate for a short period of time after the outage event has started, but then transitions into low-power mode (Step 104). When in low-power mode, the meter operates in a state to reduce power consumption. The meter may power off components and halt running background functions while in low-power mode. The meter may also lower refresh rates and disable interfaces of the meter while in low-power mode.

When the voltage detected by the meter remains outside the predetermined voltage range for a predetermined period of time after the start of the outage event, the meter determines that a sustained outage has occurred (Step 105). Utility providers or a regulatory body may set the predetermined voltage ranges and predetermined periods of time of out of range voltage to determine whether an event is a sustained outage.

In response to determining that a sustained outage has occurred, the meter generates an outage notification message (Step 106). The disturbance magnitude value transmitted to the communications module in Step 103 and an outage notification message are then transmitted to a central system (Step 107). The meter nay sends the outage notification message and disturbance magnitude value separately, in sequence or simultaneously. In other examples, the outage notification message includes the disturbance magnitude value as part of the outage notification message.

### Exemplary Method of Operation of a Meter During a Momentary Outage

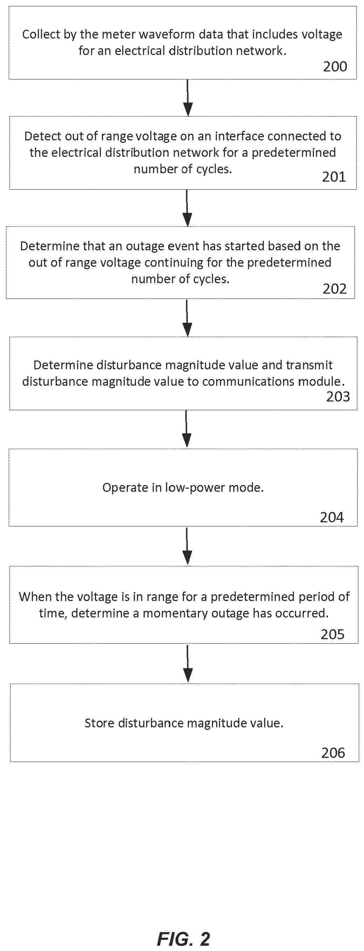

Fig. 2 is a flowchart illustrating an exemplary method of operation of a meter during a momentary outage.

The method starts at Step 200, where the meter collects waveform data that includes voltage associated with an electrical distribution network. The meter detects out of range voltage on an interface connected to the electrical distribution network for a predetermined number of cycles (Step 201) and based on the detected out of range voltage continuing for a predetermined number of cycles or predetermined period of time, the meter determines whether an outage event has started (Step 202). The predetermined number of cycles and predetermined period of time may be adjustable by utility providers or regulatory bodies.

The meter may continue to operate for a short period of time after the outage event has started, during which it determines the disturbance magnitude value. The meter transmits the disturbance magnitude value to a communications module associated with the meter (Step 203). Sometime after transmitting the disturbance magnitude value to the communications module, the meter begins operating in low-power mode (Step 204). While in low-power mode, the meter reduces power consumption to extend the length of time the meter may operate without being powered by the electrical distribution network. For example, the meter may reduce background processes, power-off components, or put other components such as the communications module in an idle mode.

When the outage event terminates, i.e., the voltage returns to an acceptable voltage range for a predetermined period of time or number of cycles, the meter determines that the outage event was a momentary outage (Step 205). The meter may store the disturbance magnitude value in memory. It may be associated with the momentary outage event, as well as additional information about the momentary outage event (Step 206). The disturbance magnitude value may be stored in a buffer or other memory storage.

The central system may query the meter for information about the momentary outage event, including the disturbance magnitude value or the meter may include the disturbance magnitude value in a scheduled communication to the central system.

### Exemplary Operation of the Meter During a Sustained Outage

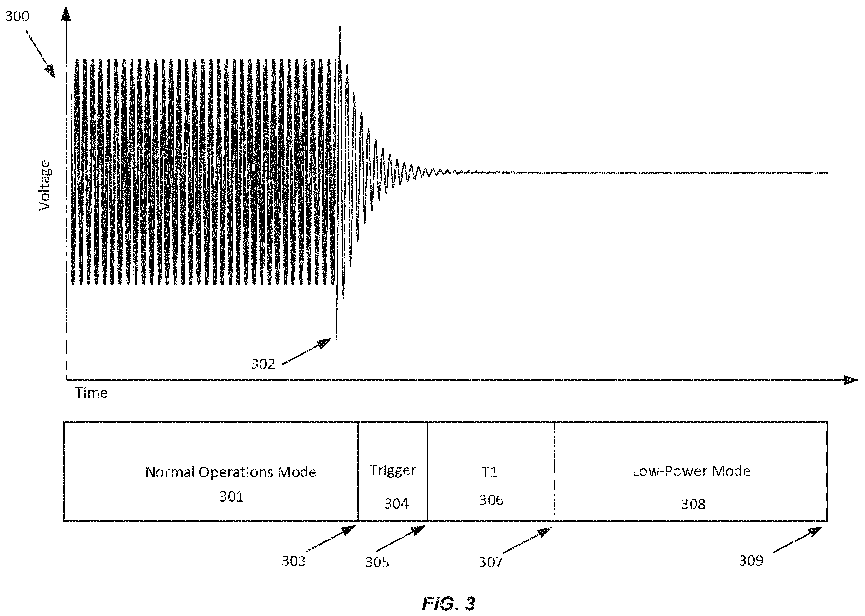

Fig. 3 illustrates exemplary operation of the meter during a sustained outage event. Graph 300 represents voltage at an interface of the meter connected to the electrical distribution network over time. Below the graph is a block diagram indicating operations of the meter over the same period of time. At the left-hand side of Fig. 3, the voltage is within a normal operating range and the meter operates normally during normal operations mode 301.

Graph 300 also depicts a spike in voltage representing a fault occurring at 302 followed by a sustained outage event. The fault occurring at 302 may be caused by a downed power line, a destroyed transformer, or other occurrence that leads to an outage.

In some examples, graph 300 may not include an identifiable fault occurring at 302. The voltage at the meter may decay or drop over a period of time until the voltage is out of the predetermined range without initially spiking. For example, a meter located further away from the fault may not detect a voltage spike, but only the voltage decay. In another example where a power asset degrades over time leading to lower efficiency of the power asset, a meter monitoring the power asset or premises associated with the power asset may detect a decay in voltage over a longer period of time.

The meter performs normal operations while in a normal operations mode 301. The meter continues to perform normal operations until detecting out of range voltage at 303. At the beginning of time period 303, the meter detects a voltage that indicates a power outage, for example, a voltage with an amplitude less than 80% of required nominal amplitude. The meter monitors the voltage for a predetermined amount of time (e.g. 2 cycles) described in Fig. 3 as a trigger 304. Where the voltage continues to be out of range for a predetermined period of time representing the trigger 304, the meter determines that an outage has started, shown at 305. The length of time of trigger 304 may also be based on a number of cycles of the voltage and a predetermined number of out of range local maxima or minima monitored by the meter.

The meter determines the disturbance magnitude value during T1 306 using waveform data collected by the meter prior to the start of the outage event and up to the time the meter calculates the disturbance magnitude value. During T1 306, the meter continues operations and prepares to operate in low-power mode 308, and transmits the disturbance magnitude value to a communications module. The amount of time T1 306 may be fixed or variable. In some examples, time T1 306 may cover ten to a hundred line cycles. In other examples, the disturbance magnitude value may be calculated using ten line cycles prior to T1 306 in addition to thirty line cycles of data after T1 306 to calculate the disturbance magnitude value. The meter may prepare to transition to low-power mode by running the communications module on idle mode, powering down components such as components related to WiFi, shutting down volatile memory, halting background functions, and other actions to reduce power consumption of the meter.

At 307, the meter transitions to operate in low-power mode 308. When the outage persists to 309, the meter determines that the outage is a sustained outage, and transmits an outage notification message and the disturbance magnitude value to the central system. The meter may power down at 309 after transmitting the outage notification message and disturbance magnitude value.

The amount of time that the meter can continue to operate after the start of an outage event may be based on technical specifications of the meter, such as battery capacity, power consumption of the meter in normal operations mode and low power mode, and other technical specifications of the meter. In one example, the meter can operate for approximately 2 seconds after the start of the outage event before powering down at 309. In this example, T1 is approximately 200 ms and the time in low-power mode is approximately 1800 ms. In another example, the meter can operate for approximately 30 seconds after the start of an outage event. In such an example, T1 306 may be 500 ms, and low-power mode 308 may persist for 30 seconds.

### Exemplary Operation of a Meter During a Momentary Outage

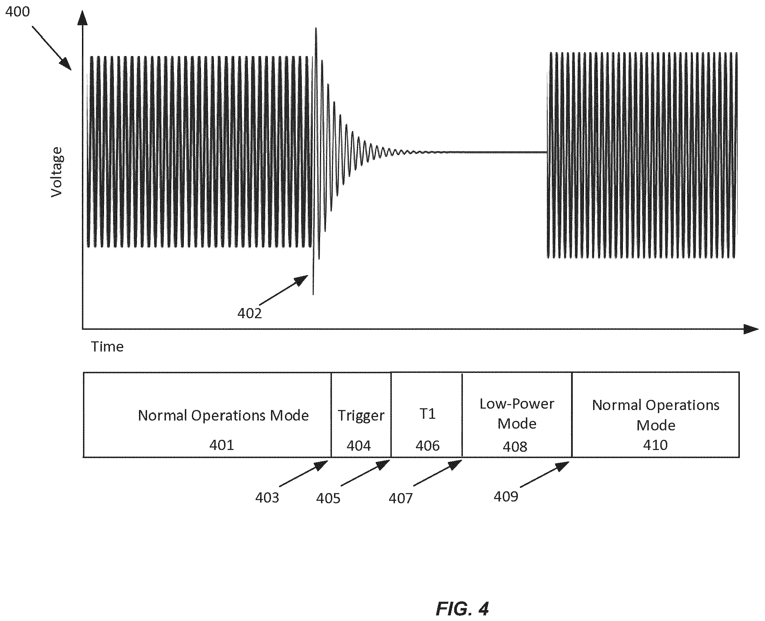

Fig. 4 illustrates operation of the meter during a momentary outage event. Graph 400 represents voltage at an interface of the meter connected to the electrical distribution network over time. Below the graph is a block diagram indicating the operations of the meter over the same period of time. At the left-hand side of Fig. 4, the voltage is within a normal operating range and the meter operates normally during normal operations mode 410. Graph 400 further depicts a fault occurring at 402 followed by a momentary outage.

The meter continues to operate normally in normal operations mode 401 until 403. At the beginning of time period 403, the meter detects voltage that indicates a power outage, for example, voltage with an amplitude less than 80% of the required nominal amplitude or voltage out of a predetermined voltage range. The meter monitors the voltage for a predetermined amount of time described in Fig. 4 as trigger 404, and when the voltage remains out of the predetermined voltage range, the meter determines that an outage event has started at time 405.

During time period T1 406, the meter determines the disturbance magnitude value, transmits the disturbance magnitude value to a communications module, and prepares the meter for low-power mode 408. The meter may prepare to transition to low-power mode 408 by running the communications module on idle mode, powering down components such as components related to WiFi, shutting down volatile memory, halting background functions, and other actions to reduce power consumption of the meter.

At 407, the meter transitions to low-power mode 408, where the meter remains until the meter detects that the outage event has terminated, e.g., the meter detects in range voltage for a predetermined period of time or number of cycles. Once the meter detects that the outage event has terminated at 409, the meter transitions to normal operations mode 410.

In Fig. 4, since power is restored to the meter before the meter determined that the outage was a sustained outage, the meter determines that the outage was a momentary outage event. In some examples, after the meter determines that the outage was a momentary outage event, the meter stores the disturbance magnitude value previously sent to the communications module during T1. The disturbance magnitude value may be stored along with other information related to the momentary outage event, as discussed above in connection with Fig. 2.

The meter may receive a message from the central system indicating that maintenance is to be conducted on the electrical distribution network at a scheduled time. In such an example, the meter may determine not to send an outage notification message or determine a disturbance magnitude value during the scheduled maintenance.

In further examples, the meter may also be configured to calculate impedance, or other characteristics associated with the electrical distribution network. The meter may use calculated impedance and other characteristics to determine whether the voltage is likely out of range because of a loading issue, such as higher than expected loads from consumers, and may determine not to send an outage message or determine a disturbance magnitude value for the loading issue.

### Exemplary Method of Storing Disturbance Magnitude Values

Instead of determining a disturbance magnitude value after an outage event has started, the meter may calculate a disturbance magnitude value as the waveform data is collected and store the disturbance magnitude value. The meter may be configured to maintain a predetermined number of the most recent disturbance magnitude values.

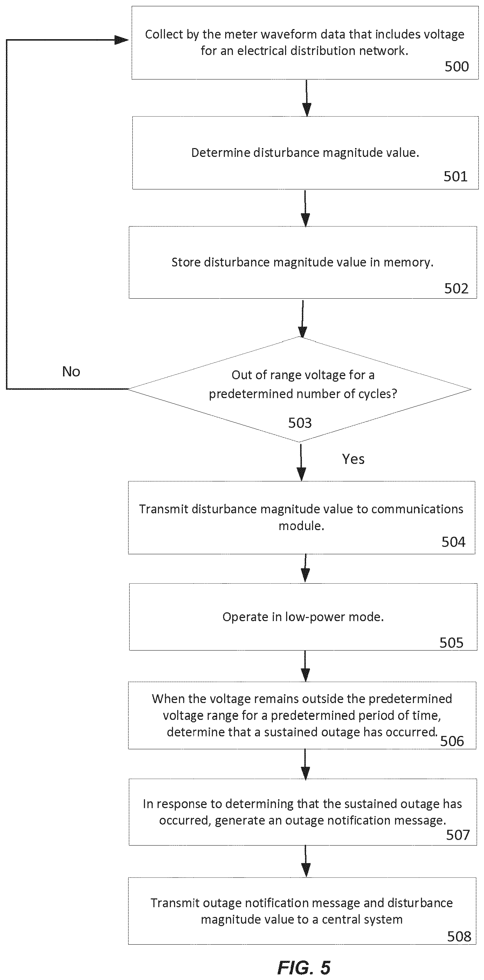

Fig. 5 is a flowchart illustrating an exemplary method of operation of a meter storing disturbance magnitude values and using a stored disturbance magnitude value when reporting a sustained outage event. The method begins at step 500, with the meter collecting waveform data such as voltage associated with an electrical distribution network.

The meter then determines a disturbance magnitude value based on the collected waveform data (Step 501). After calculating the disturbance magnitude value, the meter stores the disturbance magnitude value in memory (Step 502).

The method continues to Step 503, where the meter determines whether the meter detects out of range voltage for a predetermined number of cycles or for a predetermined period of time.

When the voltage is not out of range, the method returns to Step 500. When the voltage is out of range, the meter detects the start of an outage event. Although Fig. 5 illustrates that Step 503 follows Steps 500-502, Step 503 may be performed in parallel to Steps 500-502.

After the meter detects the start of an outage event, the meter transmits a stored disturbance magnitude value to the communications module (Step 504). When the meter stores multiple disturbance magnitude values, the meter selects the disturbance magnitude value associated with a time period prior to the time identified by the meter as the start of the outage event.

The meter then operates in low-power mode (Step 505) where the meter operates in a state to reduce power consumption. The meter may reduce power consumption by powering off components and halting running background functions while in low-power mode. The meter may also lower refresh rates and disable interfaces of the meter while in low-power mode.

When the voltage detected by the meter remains outside the predetermined voltage range for a predetermined period of time or number of cycles, the meter determines that a sustained outage event has occurred (Step 506) and the meter generates an outage notification message in response to determining a sustained outage event has occurred (Step 507).

The disturbance magnitude value transmitted to the communications module in Step 504 and the outage notification message are then transmitted to a central system (Step 508). The meter may send the outage notification message and disturbance magnitude value separately, in sequence or simultaneously. In other examples, the outage notification message includes the disturbance magnitude value as part of the outage notification message.

In one example, the meter may calculate the disturbance magnitude value after six line cycles. The meter may store the most recent four disturbance magnitude values in a circular buffer that is updated after six line cycles. In such an example, the meter may also include an outage detection algorithm that determines an outage has occurred after ten consecutive line cycles with no measured values above an outage threshold. When the meter determines that an outage has occurred, the meter may send the disturbance magnitude value associated with the window of time that contains the last line cycle where a measured value above the outage threshold occurred. The meter may compare the time of the start of the outage to the times of the other disturbance magnitude values to find the disturbance magnitude value associated with the line cycle where a measured value above the outage threshold occurred

### Exemplary Meter

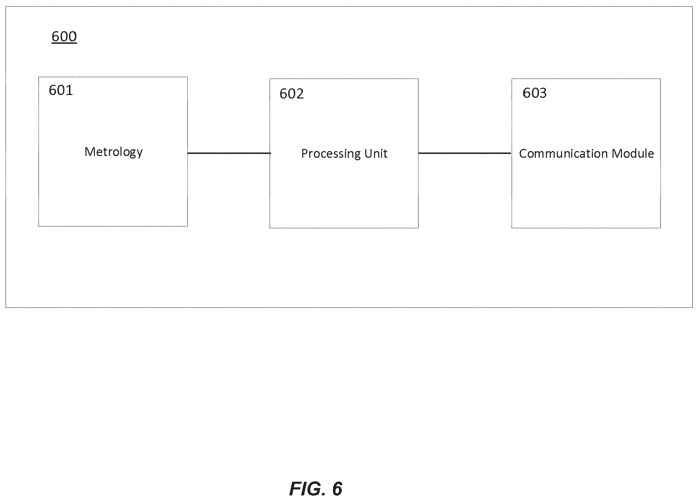

The foregoing describes that the meter performs a variety of functions, including metrology functions, processing functions, and communications functions. In some implementations, these functions may be performed by different components. Fig. 6 depicts a meter 600 that includes metrology components 601, a processing unit 602, and a communications module 603. The processing unit 602 may be configured to run one or more metering application programs to provide advanced functions, including the calculation of the disturbance magnitude value. It is also referred to herein as an EIC (edge intelligence computer).

The meter may also include additional components. For example, memory may be a separate component, or may be included in one or more of the individual components 601, 602, and 603. A processor or processing unit may also be included in any of the components. The processors may execute computer-readable instructions to configure the processors to perform the functions of the meter, including the metrology functions, processing functions, and communications functions described herein. The instructions may be stored in a computer-readable medium.

The metrology components 601 may measure voltage, current, or other characteristics of the electrical distribution network and may perform some processing of the measurements, including the generation of the waveform data. The processing unit 602 may process waveform data to calculate the disturbance magnitude value and send the disturbance magnitude value to the communications module. The processing unit may also buffer the waveform data.

The communications module 603 may send the power outage notification message, including the disturbance magnitude value, to the central system. The communications module may also facilitate other communications between the meter and the central system or other devices.

In other implementations, the components may be arranged differently, the functions may be performed by one or more of components, or the components 601, 602, and 603 may be integrated together.

### Exemplary Operating Environment

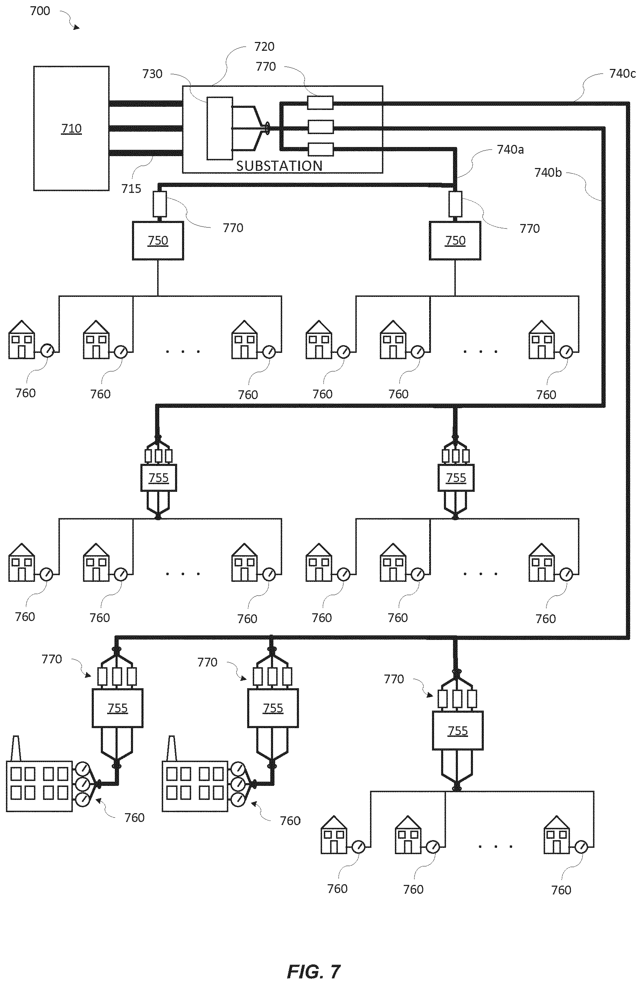

Fig. 7 represents an exemplary electrical distribution network. The electrical distribution network includes power generator 710, which may be a power generation facility or a power generator at a power generation facility. The power generator 710 may generate 3-phase alternating current (AC) power and transmit electrical power via transmission lines 715 to substation 720.

The substation 720 includes transformer 730 to step down the voltage for consumption of customers. The stepped down power is transmitted by transmission lines 740a, 740b, and 740c to transformers 750 and 755 which further step down the voltage for customer consumption.

Transformers 750 and 755 may deliver single or 3-phase power to customer premises through meters 760. The meters may monitor characteristics such as current, voltage, and power, and may be multi-phase meters. Sensors (not depicted in Fig. 7) may also be included throughout the electrical distribution network and may monitor characteristics of the electrical distribution network. Further, other power assets other than those depicted may also be included in the electrical distribution network.

A central system maintains topology information regarding the geographical location of meters 760, sensors (not depicted), and power assets as well as topology information regarding the connection of meters 760, sensors, and other power assets within the electrical distribution network.

When an outage occurs, the central system receives outage notification messages including disturbance magnitude values from multiple meters 760. Typically, only some of the outage notification messages sent by the meters 760 reach the central system so the central system analyzes the received messages and interpolates an outage area based on the received messages and the topology information maintained by the central system. Determining an outage area based on interpolation is also referred to as outage scaling. The system may generate one or more images to visually represent the outage area.

The central system analyzes the disturbance magnitude values to identify local maximums and considers the topology information to identify a fault location. In one example, the central system receives power outage notification messages from 3 meters, Meter A, Meter B, and Meter C. The power outage notification message from Meter A includes a disturbance magnitude value of 0.3, the power outage notification message from Meter B includes a disturbance magnitude value of 0.8, and the power outage notification message from Meter C includes a disturbance magnitude value of 0.2. The topology information indicates that Meter A is located upstream (i.e., closer to a power source) of Meter B and Meter B is located upstream of Meter C and that all three meters are connected to a common power asset. The topology information may be based on a connectivity model, such as a GIS model, maintained at the central system. If the topology information is unavailable or incomplete, the central system may use geographic location information for the meters to determine that Meters A, B, and C are located in the same geographic area and their disturbance magnitude values should be compared.

The central system may determine that Meter B is the closest to the fault because its disturbance magnitude value is a local maximum. It may also determine that a likely location of the fault is a line between Meters A and B based on the relative disturbance magnitude values for the three meters and the electrical distribution network model impedance. The central system may consider the relative locations of the meters in the grid topology when determining the likely location of the fault since the value of the disturbance magnitude may depend upon whether the fault is upstream or downstream of the meter. The likely location of the fault may not always be located between the two meters with the highest disturbance magnitude values. The central system may indicate the likely location of the fault on an image of the outage area.

Once the central system determines that there is an outage, it may continue to analyze any newly received power outage notification messages and disturbance magnitude values and to update the outage area and likely fault location. In one implementation, the analysis is repeated on a cycle, such as every 30 seconds so long as there is an outage.

The likely outage location may be used to control an outage response. An outage response may include determining an outage area, determining an outage response plan, including selecting and reconfiguring a power asset to restore power to a premises, identifying an asset as a priority asset for purposes of repair or maintenance, identifying repair or maintenance resources located proximate to the outage location, and deploying repair or maintenance resources to the area that includes the likely outage location, and exchanging communications with utility personnel, customers, or others. The disturbance magnitude values may allow faster and more efficient resolution of an outage. Identifying the likely outage location may also allow more specific communications to customers based on the relative distance of a customer's premises to the likely outage location so that different power restoration estimates may be provided to different customers within the same outage area.

The central system may also analyze disturbance magnitude values associated with momentary outages. The central system may receive messages from a meter that includes a disturbance magnitude value associated with a momentary outage. The disturbance magnitude value may be included as additional data in a message regularly sent to the central system (e.g., an event reporting message), included in a message sent to report a momentary outage, or sent in reply to a request from the central system for momentary outage information. When the meter initiates the message it may send that message periodically instead of in response to detecting the momentary outage.

The central system may analyze the disturbance magnitude values associated with momentary outages on a periodic basis, such as once a day. The central system may consider a time associated with the disturbance magnitude values received from different meters to determine whether the disturbance magnitude values relate to the same event. In one example, the system uses a predetermined time tolerance window (such as one minute) to identify disturbance magnitude values associated with the same event.

The analysis may identify local maximums and consider the topology information to identify a location, similar to the analysis performed for sustained outages. The identified location may correspond to a fault, including an intermittent fault, in the electrical distribution network or it may correspond to an area that may require maintenance, such an area around a line that requires maintenance to manage surrounding vegetation or animal access.

### Exemplary Communication Network

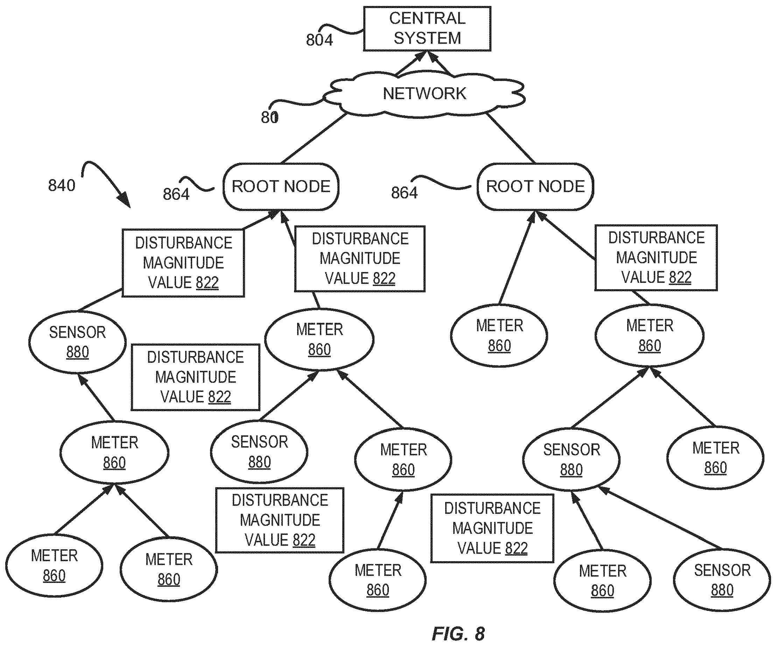

The central system 804 receives disturbance magnitude values 822 through a communications network as shown in Fig. 8. Fig. 8 is a wireless mesh network 840 that allows meters 860 and sensors 880 to communicate with other remote devices such as other meters 860, sensors 880, and central system 804.

The meters 860 and sensors 880 send disturbance magnitude values 822 to other meters 860 and sensors 880 to reach their respective root nodes 864. The meters 860 and sensors 880 may communicate to each other through various wireless and wired communication technologies including: RF, satellite, 3g, 4g, UHB, PLC, WiFi, and other communication technologies.

The root nodes may be personal area network coordinators, gateways, or other devices capable of communicating with the central system 804 and other devices on the mesh network. Further, the root nodes 864 forward disturbance magnitude values to the central system through network 810.

The central system 804 receives disturbance magnitude values forwarded by the root nodes 864 from the meters 860 and 804. In some examples, the meters 860 are configured to stream disturbance magnitude values and other information by the root nodes 864 to the central system 804. The central system 804 may also query disturbance magnitude values from meters 860 and sensors 880.

While the present subject matter has been described in detail with respect to specific aspects thereof, it will be appreciated that those skilled, upon attaining an understand of the foregoing, may readily produce alternations to, or variations of, such aspects. Accordingly , it should be understood that the present disclosure has been presented for purposes of example rather than limitation and does not preclude inclusion of such modifications, variations, and/or additions to the present subject matter as would be readily apparent to one of ordinary skill in the art. The invention is defined by the claims.

## Claims

1. A method of operation of a meter, the method comprising:
collecting (200) waveform data that includes voltage data for an electrical distribution network;
detecting (201) voltage values outside a predetermined voltage range on an interface connected to the electrical distribution network for a predetermined number of cycles;
determining (202) that an outage event has started based on the out of range voltage continuing for the predetermined number of cycles;
determining (203) a disturbance magnitude value;
transmitting (203) the disturbance magnitude value to a communications module of the meter;
beginning (204) to operate in a low-power mode;
determining (205) that the outage event is a momentary outage event based on the voltage of the electrical distribution network being within the predetermined voltage range for a predetermined period of time; and
storing (206) the disturbance magnitude value in a memory of the meter.

2. The method of claim 1, further comprising including the disturbance magnitude value in a scheduled communication to a central system of the electrical distribution network.

3. The method of claim 1 or 2, further comprising storing the waveform data in a buffer.

4. The method of claim 3, wherein determining the disturbance magnitude value comprises:
accessing the stored waveform data; and
using the stored waveform data collected prior to a start of the outage event to calculate a disturbance magnitude value for the outage event.

5. The method of claim 3, wherein an application program operating on the meter calculates the disturbance magnitude value, and wherein determining a disturbance magnitude value includes notifying the application program that the outage event has started and causing the application program to access the stored waveform data and to calculate the disturbance magnitude value.

6. The method of any of claims 3 to 5, wherein the meter maintains the buffer to include waveform data for a predetermined number of recent cycles.

7. The method of any preceding claim, wherein the meter is a multi-phase meter and the voltage or current data for an electrical distribution network includes voltage or current data for multiple phases.

8. The method of any preceding claim, wherein the disturbance magnitude value identifies a relative distance of the meter compared to other meters in the electrical distribution network to a fault in the electrical distribution network associated with the outage event.

9. A meter comprising a processor configured to:
collect (200) waveform data that includes voltage data for an electrical distribution network;
detect (201) voltage values outside a predetermined voltage range on an interface connected to the electrical distribution network for a predetermined number of cycles;
determine (202) that an outage event has started based on the out of range voltage continuing for the predetermined number of cycles;
determine (203) a disturbance magnitude value;
transmit (203) the disturbance magnitude value to a communications module of the meter;
begin (204) to operate in a low-power mode;
determine (205) that the outage event is a momentary outage event based on the voltage of the electrical distribution network being within the predetermined voltage range for a predetermined period of time; and
store (206) the disturbance magnitude value in a memory of the meter.

## Patentansprüche

1. Betriebsverfahren für ein Messgerät, wobei das Verfahren Folgendes umfasst:
Sammeln (200) von Wellenformdaten, die Spannungsdaten für ein Stromverteilungsnetz einschließen;
Erfassen (201) von Spannungswerten außerhalb eines vorbestimmten Spannungsbereichs an einer mit dem elektrischen Leistungsnetz verbundenen Schnittstelle für eine vorbestimmte Anzahl von Zyklen;
Bestimmen (202), dass ein Ausfallereignis begonnen hat, basierend darauf, dass die Spannung für die vorbestimmte Anzahl von Zyklen außerhalb der vorbestimmten Spannung andauern;
Bestimmen (203) eines Störungsgrößenwerts;
Übertragen (203) des Störungsgrößenwerts an ein Kommunikationsmodul des Messgeräts;
Beginnen (204), in einem Niederleistungsmodus zu arbeiten;
Bestimmen (205), dass das Ausfallereignis ein momentanes Ausfallereignis ist, basierend darauf, dass die Spannung des Stromverteilungsnetzes für eine vorbestimmte Zeitdauer innerhalb des vorbestimmten Spannungsbereichs liegt; und
Speichern (206) des Störungsgrößenwerts in einem Speicher des Messgeräts.

2. Verfahren nach Anspruch 1, das ferner Einschließen des Störungsgrößenwerts in eine geplante Kommunikation mit einem zentralen System des Stromverteilungsnetzes umfasst.

3. Verfahren nach Anspruch 1 oder 2, das ferner Speichern den Wellenformdaten in einem Puffer umfasst.

4. Verfahren nach Anspruch 3, wobei Bestimmen des Verteilungsgrößenwerts Folgendes umfasst:
Zugreifen auf die gespeicherten Wellenformdaten; und
Verwenden der gespeicherten Wellenformdaten, die vor Beginn des Ausfallereignisses gesammelt wurden, um einen Störungsgrößenwert für das Ausfallereignis zu berechnen.

5. Verfahren nach Anspruch 3, wobei ein auf dem Messgerät laufendes Anwendungsprogramm den Störungsgrößenwert berechnet, und wobei Bestimmen eines Störungsgrößenwerts Benachrichtigen des Anwendungsprogramms über den Beginn des Ausfallereignisses und Bewirken, dass das Anwendungsprogramm auf die gespeicherten Wellenformdaten zugreift und den Störungsgrößenwert berechnet, einschließt.

6. Verfahren nach einem der Ansprüche 3 bis 5, wobei das Messgerät den Puffer so aufrechterhält, dass er Wellenformdaten für eine vorbestimmte Anzahl von kürzlichen Zyklen einschließt.

7. Verfahren nach einem vorstehenden Anspruch, wobei es sich bei dem Messgerät um ein Mehrphasenmessgerät handelt und die Spannungs- oder Stromdaten für ein Stromverteilungsnetz Spannungs- oder Stromdaten für mehrere Phasen einschließen.

8. Verfahren nach einem vorstehenden Anspruch, wobei der Störungsgrößenwert eine relative Entfernung des Messgeräts im Vergleich zu anderen Messgeräten im Stromverteilungsnetz zu einem Fehler im Stromverteilungsnetz, der dem Ausfallereignis zugeordnet ist, identifiziert.

9. Messgerät, das einen Prozessor umfasst, der für Folgendes konfiguriert ist:
Sammeln (200) von Wellenformdaten, die Spannungsdaten für ein Stromverteilungsnetz einschließen;
Erfassen (201) von Spannungswerten außerhalb eines vorbestimmten Spannungsbereichs an einer mit dem elektrischen Leistungsnetz verbundenen Schnittstelle für eine vorbestimmte Anzahl von Zyklen;
Bestimmen (202), dass ein Ausfallereignis begonnen hat, basierend darauf, dass die Spannung für die vorbestimmte Anzahl von Zyklen außerhalb der vorbestimmten Spannung andauern;
Bestimmen (203) eines Störungsgrößenwerts;
Übertragen (203) des Störungsgrößenwerts an ein Kommunikationsmodul des Messgeräts;
Beginnen (204), in einem Niederleistungsmodus zu arbeiten;
Bestimmen (205), dass das Ausfallereignis ein momentanes Ausfallereignis ist, basierend darauf, dass die Spannung des Stromverteilungsnetzes für eine vorbestimmte Zeitdauer innerhalb des vorbestimmten Spannungsbereichs liegt; und
Speichern (206) des Störungsgrößenwerts in einem Speicher des Messgeräts.

## Revendications

1. Procédé de fonctionnement d'un compteur, le procédé comprenant :
la collecte (200) des données de forme d'onde incluant des données de tension pour un réseau de distribution électrique ;
la détection (201) des valeurs de tension en dehors d'une plage de tensions prédéterminée sur une interface raccordée au réseau de distribution électrique pendant un nombre de cycles prédéterminé ;
la détermination (202) qu'un événement de panne a persisté sur la base de la tension hors plage se poursuivant pendant le nombre de cycles prédéterminé ;
la détermination (203) d'une valeur d'amplitude de perturbation ;
la transmission (203) de la valeur d'amplitude de perturbation à un module de communication du compteur ;
le démarrage (204) du fonctionnement en mode basse consommation ;
la détermination (205) que l'événement de panne est un événement de panne temporaire sur la base de la tension du réseau de distribution électrique située dans la plage de tension prédéterminée pendant une période de temps prédéterminée ; et
le stockage (206) de la valeur d'amplitude de perturbation dans une mémoire du compteur.

2. Procédé selon la revendication 1, comprenant en outre l'inclusion de la valeur d'amplitude de perturbation dans une communication planifiée vers un système central du réseau de distribution électrique.

3. Procédé selon la revendication 1 ou 2, comprenant en outre le stockage des données de forme d'onde dans une mémoire tampon.

4. Procédé selon la revendication 3, dans lequel la détermination de la valeur d'amplitude de perturbation comprend :
l'accès aux données de forme d'onde stockées ; et
l'utilisation des données de forme d'onde stockées, collectées avant le début de l'événement de panne, pour calculer une valeur d'amplitude de perturbation pour l'événement de panne.

5. Procédé selon la revendication 3, dans lequel un programme d'application fonctionnant sur le compteur calcule la valeur d'amplitude de perturbation, et dans lequel la détermination d'une valeur d'amplitude de perturbation inclut le fait de notifier au programme d'application le début de l'événement de panne, et d'amener le programme d'application à accéder aux données de forme d'onde stockées pour calculer la valeur d'amplitude de perturbation.

6. Procédé selon l'une quelconque des revendications 3 à 5, dans lequel le compteur maintient la mémoire tampon pour inclure des données de forme d'onde pendant un nombre prédéterminé de cycles récents.

7. Procédé selon une quelconque revendication précédente, dans lequel le compteur est un compteur polyphasé et les données de tension ou de courant pour un réseau de distribution électrique incluent des données de tension ou de courant pour plusieurs phases.

8. Procédé selon une quelconque revendication précédente, dans lequel la valeur d'amplitude de perturbation identifie une distance relative du compteur par rapport à d'autres compteurs du réseau de distribution électrique jusqu'à un défaut survenu dans le réseau de distribution électrique associé à l'événement de panne.

9. Compteur comprenant un processeur configuré pour :
collecter (200) des données de forme d'onde incluant des données de tension pour un réseau de distribution électrique ;
détecter (201) des valeurs de tension en dehors d'une plage de tensions prédéterminée sur une interface raccordée au réseau de distribution électrique pendant un nombre de cycles prédéterminé ;
déterminer (202) qu'un événement de panne a persisté sur la base de la tension hors plage se poursuivant pendant le nombre de cycles prédéterminé ;
déterminer (203) une valeur d'amplitude de perturbation ;
transmettre (203) la valeur d'amplitude de perturbation à un module de communication du compteur ;
commencer (204) à fonctionner en mode basse consommation ;
déterminer (205) que l'événement de panne est un événement de panne temporaire basé sur la tension du réseau de distribution électrique se situant dans la plage de tension prédéterminée pendant une période de temps prédéterminée ; et
stocker (206) la valeur d'amplitude de perturbation dans une mémoire du compteur.
